# EUROPEAN PATENT APPLICATION

(11) **EP 4 261 827 A1**
(43) Date of publication of application: **18.10.2023**
(21) Application number: 22868421.3
(22) Date of filing: 28.06.2022
(51) Int. Cl.: G11C 29/56

(54) **METHOD AND APPARATUS FOR IMPLEMENTING MIRROR IMAGE STORAGE OF MEMORY MODEL, AND STORAGE MEDIUM**

(30) Priority: 01.03.2022 CN 202210195444
(71) Applicant: BEIJING BAIDU NETCOM SCIENCE AND TECHNOLOGY CO. LTD., 100085 Beijing (CN)
(72) Inventor: JIN, Xin, Beijing 100085 (CN)
(74) Representative: dompatent von Kreisler Selting Werner - Partnerschaft von Patent- und Rechtsanwälten mbB
(86) International application number: PCT/CN2022/101758
(87) International publication number: WO 2023/165058

(57) **Abstract**

The present disclosure provides a method and apparatus of mirroring storage implementation for a memory model, and a storage medium, and relates to the field of artificial intelligence (AI) such as AI chips and intelligent voice. The method may include: acquiring, in response to a data update behavior occurring in a memory in a device under test (DUT), update behavior information of the update, the update behavior information being extracted from a bus; and correspondingly updating data stored in the memory model according to the update behavior information. By use of the solutions of the present disclosure, valid memory verification and the like can be achieved.

## Description

This application claims priority to Chinese Patent Application No. 202210195444.X, entitled "MIRRORING STORAGE IMPLEMENTATION METHOD AND APPARATUS FOR MEMORY MODEL, AND STORAGE MEDIUM", and filed on March 1, 2022.

### Field of the Disclosure

The present disclosure relates to the technical field of artificial intelligence (AI), and in particular, to a method and apparatus of mirroring storage implementation for a memory model, and a storage medium in fields such as AI chips and intelligent voice.

### Background of the Disclosure

Current verification of chips is generally implemented based on a universal verification methodology (UVM) verification platform. The chips may be intelligent voice chips, or the like. However, functions of the current UVM verification platform are in need of further improvement.

### Summary of the Disclosure

The present disclosure provides a method and apparatus of mirroring storage implementation for a memory model, and a storage medium.

A method of mirroring storage implementation for a memory model, the method including:
acquiring, in response to a data update behavior occurring in a memory in a device under test (DUT), update behavior information of the update, the update behavior information being extracted from a bus; and
correspondingly updating data stored in the memory model according to the update behavior information.

An apparatus of mirroring storage implementation for a memory model, the apparatus including: an information acquisition module and a data update module;
the information acquisition module being configured to acquire, in response to a data update behavior occurring in a memory in a DUT, update behavior information of the update, the update behavior information being extracted from a bus; and
the data update module being configured to correspondingly update data stored in the memory model according to the update behavior information.

An electronic device, including:
at least one processor; and
a memory in communication connection with the at least one processor; wherein
the memory stores commands executable by the at least one processor, and the commands are executed by the at least one processor to enable the at least one processor to perform the method as described above.

A non-transitory computer-readable storage medium storing computer commands, wherein the computer commands are configured to cause a computer to perform the method as described above.

A computer program product, including a computer program/command, wherein, when the computer program/command is executed by a processor, the method as described above is performed.

One of the above disclosed embodiments has the following advantages or beneficial effects. The update behavior information corresponding to the data update behavior occurring in the memory in the DUT can be acquired through the bus, and the memory model can be updated correspondingly according to the acquired information, which realizes a mirroring storage function of the memory model, and then can effectively realize memory verification in chip verification based on the stored data and correspondingly improve a verification effect of the chip verification, etc.

It should be understood that the content described in this part is neither intended to identify key or significant features of the embodiments of the present disclosure, nor intended to limit the scope of the present disclosure. Other features of the present disclosure will be made easier to understand through the following description.

### Brief Description of Drawings

The accompanying drawings are intended to provide a better understanding of the solutions and do not constitute a limitation on the present disclosure. In the drawings,
FIG. 1 is a flowchart of an embodiment of a method of mirroring storage implementation for a memory model according to the present disclosure;
FIG. 2 is a schematic architectural diagram of a verification environment corresponding to the method according to the present disclosure;
FIG. 3 is a schematic diagram of a composition structure of a first embodiment of an apparatus of mirroring storage implementation for a memory model 300 according to the present disclosure;
FIG. 4 is a schematic diagram of a composition structure of a second embodiment of an apparatus of mirroring storage implementation for a memory model 400 according to the present disclosure; and
FIG. 5 is a schematic block diagram of an electronic device 500 that may be configured to implement an embodiment of the present disclosure.

### Detailed Description of Preferred Embodiments

Exemplary embodiments of the present disclosure are illustrated below with reference to the accompanying drawings, which include various details of the present disclosure to facilitate understanding and should be considered only as exemplary. Therefore, those of ordinary skill in the art should be aware that various changes and modifications can be made to the embodiments described herein without departing from the scope and spirit of the present disclosure. Similarly, for clarity and simplicity, descriptions of well-known functions and structures are omitted in the following description.

In addition, it should be understood that the term "and/or" herein is merely an association relationship describing associated objects, indicating that three relationships may exist. For example, A and/or B indicates that there are three cases of A alone, A and B together, and B alone. Besides, the character "/" herein generally means that associated objects before and after it are in an "or" relationship.

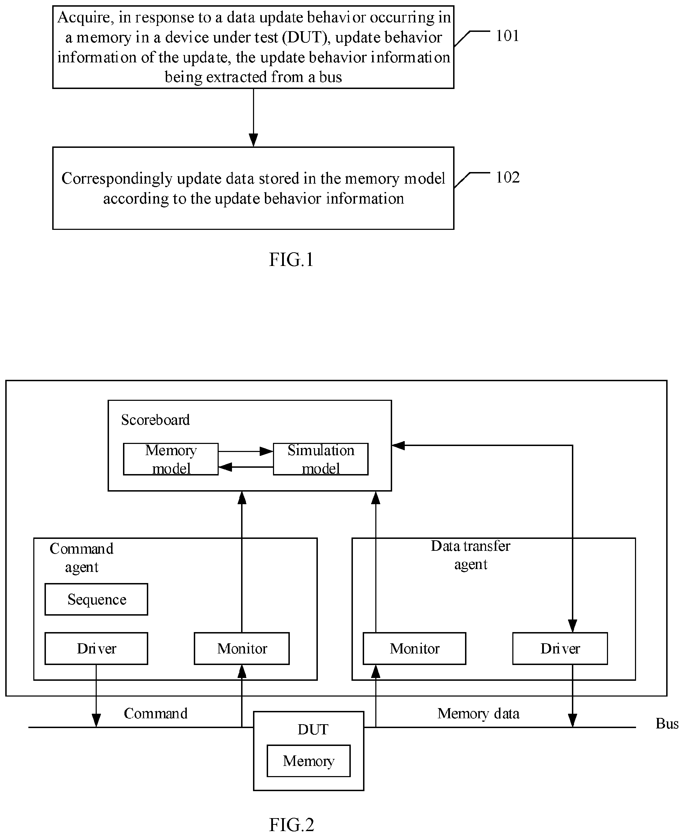

FIG. 1 is a flowchart of an embodiment of a method of mirroring storage implementation for a memory model according to the present disclosure. As shown in FIG. 1, the following specific implementation is included.

In step 101, in response to a data update behavior occurring in a memory in a device under test (DUT), update behavior information of the update is acquired, the update behavior information being extracted from a bus.

In step 102, data stored in the memory model (mem_model) is correspondingly updated according to the update behavior information.

The current UVM verification platform only supports a mirroring storage function of a register model but does not support a mirroring storage function of the memory model, thereby affecting a verification effect.

By use of the solution in the above method embodiment, the update behavior information corresponding to the data update behavior occurring in the memory in the DUT can be acquired through the bus, and the memory model can be updated correspondingly according to the acquired information, which realizes a mirroring storage function of the memory model, and then can effectively realize memory verification in chip verification based on the stored data and correspondingly improve a verification effect of the chip verification, etc.

In an embodiment of the present disclosure, the memory model may include: a memory model formed by a register block. In addition, a number of registers in the register block may be equal to a depth of the memory in the DUT, and/or a number of bits of the register may be equal to a bit width of the memory in the DUT.

In the above manner, the memory model can be constructed quickly and efficiently, thereby laying a good foundation for subsequent processing.

In addition, the above memory model can also be instantiated. For example, the memory model can be instantiated in a scoreboard for practical use.

When a data update behavior occurs in the memory in the DUT, update behavior information of the update may be acquired, and data stored in the memory model may be correspondingly updated according to the update behavior information.

The data update behavior occurring in the memory in the DUT mainly includes two situations, which are introduced below respectively.

### 1) Situation 1

In this situation, the data update behavior may include external bus input update. That is, a data update behavior for the memory in the DUT occurs on the bus. For example, the DUT reads data as a master device or the DUT writes data as a slave device.

Correspondingly, the update behavior information may include an update address and data. That is, the update address and data of the update may be acquired, and the update address and data may be extracted from the bus.

Further, the data stored in the memory model according to the update behavior information may be correspondingly updated. That is, the data corresponding to the update address in the memory model may be updated to the data in the update behavior information.

In the above manner, synchronous update of the data in the memory model and in the memory of the DUT can be realized. In addition, the bus may support various interface protocol types such as an advanced peripheral bus (APB), an advanced high performance bus (AHB), and an advanced extensible interface (AXI), and is widely applicable.

### 2) Situation 2

In this situation, the data update behavior may include update after internal processing of the DUT. For example, a computation command may be initiated to the DUT from the bus. Correspondingly, the DUT may acquire source data corresponding to the computation command and execute computation corresponding to the computation command to obtain a computation result, and then store the computation result in a destination address area of the memory.

Since the data (computation result) is updated into the memory inside the DUT after logic processing inside the DUT, the data cannot be extracted from the bus, but the computation command sent to the DUT can be extracted from the bus. Correspondingly, the acquired update behavior information may include a computation command.

Further, the data stored in the memory model according to the update behavior information may be correspondingly updated. That is, source data corresponding to the computation command may be acquired, a computation result generated according to the source data may be acquired, and then the computation result may be updated into the memory model.

In an embodiment of the present disclosure, the source data may be sent to a simulation model (cmodel), and the computation result obtained after the simulation model executes computation corresponding to the computation command according to the source data may be acquired.

The simulation model is a simulation model of the DUT. It may be considered that the computation result of the simulation model is an ideal and accurate computation result. Correspondingly, the computation result of the simulation model may be called an expected value.

In practical applications, the source data corresponding to the computation command may be acquired from the memory model, and the acquired expected value may be updated into the destination address area in the memory model.

In the above manner, the expected value of the memory can be mirrored to facilitate subsequent data comparison, etc.

Specifically, in an embodiment of the present disclosure, corresponding data may be acquired from the memory model according to an output address extracted from the bus in response to a memory data output behavior occurring in the DUT, and output data extracted from the bus may be compared with the data acquired from the memory model.

If the DUT receives a memory data output command, that is, a memory data output behavior is initiated to the DUT on the bus, for example, if the DUT writes data to an external device as a master device or the DUT reads data as a slave device, an output address and output data can be extracted from the bus. Correspondingly, the corresponding data may be acquired from the memory model according to the output address, and the output data may be compared with the data (expected value) acquired from the memory model.

In the above manner, it can effectively verified whether the data stored in the memory is consistent with the expected value, thereby realizing valid memory verification, that is, realizing chip logic function verification.

Based on the above introduction, FIG. 2 is a schematic architectural diagram of a verification environment corresponding to the method according to the present disclosure. As shown in FIG. 2, components such as a scoreboard, a command agent (cmd_agent), and a data transfer agent may be included. The command agent may further include components such as a sequence (seqr), a driver, and a monitor. The data transfer agent may further include components such as a driver and a monitor. The scoreboard may further include components such as a memory model and a simulation model. The method in the present disclosure may be performed by the scoreboard.

The memory model may be a memory model formed by a register block. A number of registers in the register block may be equal to a depth of the memory in the DUT, and a number of bits of the register may be equal to a bit width of the memory in the DUT.

Based on the method in the present disclosure, single command function verification can be realized. The source data may be moved to the memory of the DUT through the bus.

In addition, as shown in FIG. 2, monitors may be utilized to identify behaviors of the bus and extract information from the bus. Specific operation manners of the monitors are prior arts.

If it is identified that a data update behavior of external bus input update occurs in the memory in the DUT, for the update behavior information such as an update address and data extracted from the bus, the scoreboard may correspondingly update data stored in the memory model according to the update behavior information, that is, may update the data corresponding to the update address in the memory model to the data in the update behavior information.

If it is identified that a data update behavior of update after internal processing of the DUT occurs in the memory in the DUT, for the update behavior information such as a computation command extracted from the bus, the scoreboard may correspondingly update data stored in the memory model according to the update behavior information, that is, may acquire source data corresponding to the computation command, acquire a computation result generated according to the source data, and update the computation result into the memory model.

Specifically, the scoreboard may acquire source data from the memory model, send the source data to the simulation model, acquire a computation result, i.e., an expected value, obtained after the simulation model executes computation corresponding to the computation command according to the source data, and update the computation result into the memory model.

If it is identified that a memory data output behavior occurs in the DUT, for an output address and output data extracted from the bus, the scoreboard may acquire corresponding data from the memory model according to the output address, and compare the output data with the data acquired from the memory model, so as to complete required data comparison.

In practical applications, various use cases of single command function verification may also be flexibly spliced and combined to realize multi-command continuous function verification, etc.

It is to be noted that, to make the description brief, the foregoing method embodiments are expressed as a series of actions. However, those skilled in the art should appreciate that the present disclosure is not limited to the described action sequence, because according to the present disclosure, some steps may be performed in other sequences or performed simultaneously. In addition, those skilled in the art should also appreciate that all the embodiments described in the specification are preferred embodiments, and the actions and modules involved are not necessarily mandatory to the present disclosure.

In brief, by use of the method in the present disclosure, the memory model can be quickly and efficiently constructed, and the mirroring storage function of the memory model can be realized, so as to support valid memory verification, thereby improving the verification effect of the chip verification, etc.

The above is the introduction to the method embodiments. The following is a further illustration of the solutions of the present disclosure through apparatus embodiments.

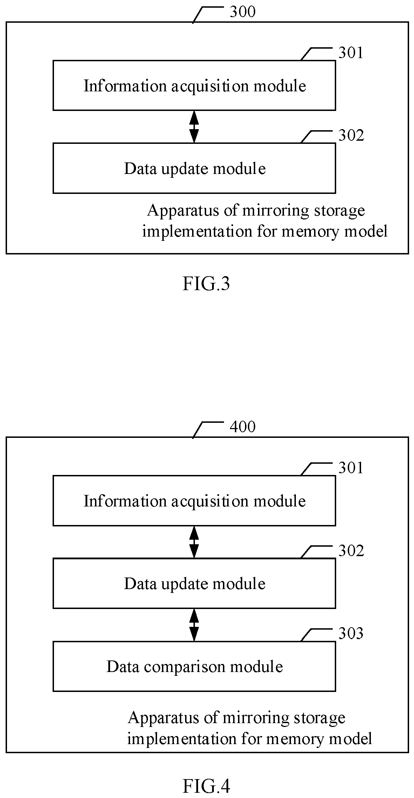

FIG. 3 is a schematic diagram of a composition structure of a first embodiment of an apparatus of mirroring storage implementation for a memory model 300 according to the present disclosure. As shown in FIG. 3, the apparatus may include: an information acquisition module 301 and a data update module 302.

The information acquisition module 301 is configured to acquire, in response to a data update behavior occurring in a memory in a DUT, update behavior information of the update. The update behavior information is extracted from a bus.

The data update module 302 is configured to correspondingly update data stored in the memory model according to the update behavior information.

By use of the solution in the above apparatus embodiment, the update behavior information corresponding to the data update behavior occurring in the memory in the DUT can be acquired through the bus, and the memory model can be updated correspondingly according to the acquired information, which realizes a mirroring storage function of the memory model, and then can effectively realize memory verification in chip verification based on the stored data and correspondingly improve a verification effect of the chip verification, etc.

In an embodiment of the present disclosure, the memory model may include: a memory model formed by a register block. In addition, a number of registers in the register block may be equal to a depth of the memory in the DUT, and/or a number of bits of the register may be equal to a bit width of the memory in the DUT.

In addition, the above memory model can also be instantiated. For example, the memory model can be instantiated in a scoreboard for practical use.

The data update behavior occurring in the memory in the DUT mainly includes two situations, which are introduced below respectively.

### 1) Situation 1

In this situation, the data update behavior may include external bus input update. That is, a data update behavior for the memory in the DUT occurs on the bus. For example, the DUT reads data as a master device or the DUT writes data as a slave device.

Correspondingly, the update behavior information may include an update address and data. That is, the update address and data of the update may be acquired, and the update address and data may be extracted from the bus.

Further, the data update module 302 may correspondingly update data stored in the memory model according to the update behavior information, that is, may update the data corresponding to the update address in the memory model to the data in the update behavior information.

### 2) Situation 2

In this situation, the data update behavior may include update after internal processing of the DUT. For example, a computation command may be initiated to the DUT from the bus. Correspondingly, the DUT may acquire source data corresponding to the computation command and execute computation corresponding to the computation command to obtain a computation result, and then store the computation result in a destination address area of the memory.

Since the data (computation result) is updated into the memory inside the DUT after logic processing inside the DUT, the data cannot be extracted from the bus, but the computation command sent to the DUT can be extracted from the bus. Correspondingly, the acquired update behavior information may include a computation command.

Further, the data update module 302 may correspondingly update data stored in the memory model according to the update behavior information, that is, may acquire source data corresponding to the computation command, acquire a computation result generated according to the source data, and update the computation result into the memory model.

In an embodiment of the present disclosure, the data update module 302 may send source data to a simulation model, and acquire the computation result obtained after the simulation model executes computation corresponding to the computation command according to the source data.

The simulation model is a simulation model of the DUT. It may be considered that the computation result of the simulation model is an ideal and accurate computation result. Correspondingly, the computation result of the simulation model may be called an expected value.

In practical applications, the data update module 302 may acquire source data corresponding to the computation command from the memory model, and update the acquired expected value into the destination address area in the memory model.

FIG. 4 is a schematic diagram of a composition structure of a second embodiment of an apparatus mirroring storage implementation for a memory model 400 according to the present disclosure. As shown in FIG. 4, the apparatus may include: an information acquisition module 301, a data update module 302, and a data comparison module 303.

Functions of the information acquisition module 301 and the data update module 302 are the same as those in the embodiment shown in FIG. 3. Details are not described again.

The data comparison module 303 may acquire corresponding data from the memory model according to an output address extracted from the bus in response to a memory data output behavior occurring in the DUT, and compare output data extracted from the bus with the data acquired from the memory model.

If the DUT receives a memory data output command, that is, a memory data output behavior is initiated to the DUT on the bus, for example, if the DUT writes data to an external device as a master device or the DUT reads data as a slave device, an output address and output data can be extracted from the bus. Correspondingly, the data comparison module 303 may acquire corresponding data from the memory model according to the output address, and compare the output data with the data (expected value) acquired from the memory model.

Specific operation flows of the apparatus embodiments shown in FIG. 3 and FIG. 4 may be obtained with reference to the related description in the above method embodiments.

In brief, by use of the apparatus in the present disclosure, the memory model can be quickly and efficiently constructed, and the mirroring storage function of the memory model can be realized, so as to support valid memory verification, thereby improving the verification effect of the chip verification, etc.

The solutions of the present disclosure may be applied to the field of AI, and in particular, relate to fields such as AI chips and intelligent voice. AI is a discipline that studies how to make computers simulate certain thinking processes and intelligent behaviors (such as learning, reasoning, thinking, and planning) of human beings, which includes hardware technologies and software technologies. The AI hardware technologies generally include sensors, dedicated AI chips, cloud computing, distributed storage, big data processing, and other technologies. The AI software technologies mainly include a computer vision technology, a speech recognition technology, a natural language processing technology, machine learning/deep learning, a big data processing technology, a knowledge graph technology, and other major directions.

The data in the embodiments of the present disclosure is not specific to a specific user and does not reflect a specific user's personal information.

Collection, storage, use, processing, transmission, provision, and disclosure of users' personal information involved in the technical solutions of the present disclosure comply with relevant laws and regulations, and do not violate public order and moral.

According to embodiments of the present disclosure, the present disclosure further provides an electronic device, a readable storage medium, and a computer program product.

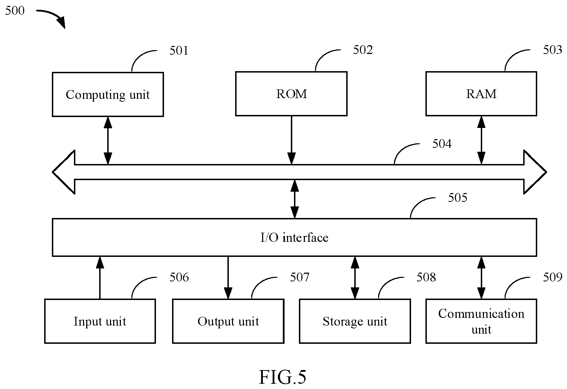

FIG. 5 is a schematic block diagram of an electronic device 500 that may be configured to implement an embodiment of the present disclosure. The electronic device is intended to represent various forms of digital computers, such as laptops, desktops, workbenches, servers, blade servers, mainframe computers, and other suitable computers. The electronic device may further represent various forms of mobile devices, such as personal digital assistants, cellular phones, smart phones, wearable devices, and other similar computing devices. The components, their connections and relationships, and their functions shown herein are examples only, and are not intended to limit the implementation of the present disclosure as described and/or required herein.

As shown in FIG. 5, the device 500 includes a computing unit 501, which may perform various suitable actions and processing according to a computer program stored in a read-only memory (ROM) 502 or a computer program loaded from a storage unit 508 into a random access memory (RAM) 503. The RAM 503 may also store various programs and data required to operate the device 500. The computing unit 501, the ROM 502, and the RAM 503 are connected to one another by a bus 504. An input/output (I/O) interface 505 is also connected to the bus 504.

A plurality of components in the device 500 are connected to the I/O interface 505, including an input unit 506, such as a keyboard and a mouse; an output unit 507, such as various displays and speakers; a storage unit 508, such as disks and discs; and a communication unit 509, such as a network card, a modem and a wireless communication transceiver. The communication unit 509 allows the device 500 to exchange information/data with other devices over computer networks such as the Internet and/or various telecommunications networks.

The computing unit 501 may be a variety of general-purpose and/or special-purpose processing components with processing and computing capabilities. Some examples of the computing unit 501 include, but are not limited to, a central processing unit (CPU), a graphics processing unit (GPU), various AI computing chips, various computing units that run machine learning model algorithms, a digital signal processor (DSP), and any appropriate processor, controller or microcontroller, etc. The computing unit 501 performs the methods and processing described above, such as the method described in the present disclosure. For example, in some embodiments, the method described in the present disclosure may be implemented as a computer software program that is tangibly embodied in a machine-readable medium, such as the storage unit 508. In some embodiments, part or all of a computer program may be loaded and/or installed on the device 500 via the ROM 502 and/or the communication unit 509. One or more steps of the method described in the present disclosure may be performed when the computer program is loaded into the RAM 503 and executed by the computing unit 501. Alternatively, in other embodiments, the computing unit 501 may be configured to perform the method described in the present disclosure by any other appropriate means (for example, by means of firmware).

Various implementations of the systems and technologies disclosed herein can be realized in a digital electronic circuit system, an integrated circuit system, a field programmable gate array (FPGA), an application-specific integrated circuit (ASIC), an application-specific standard product (ASSP), a system on chip (SOC), a complex programmable logic device (CPLD), computer hardware, firmware, software, and/or combinations thereof. Such implementations may include implementation in one or more computer programs that are executable and/or interpretable on a programmable system including at least one programmable processor, which can be special or general purpose, configured to receive data and commands from a storage system, at least one input apparatus, and at least one output apparatus, and to transmit data and commands to the storage system, the at least one input apparatus, and the at least one output apparatus.

Program codes configured to implement the methods in the present disclosure may be written in any combination of one or more programming languages. Such program codes may be supplied to a processor or controller of a general-purpose computer, a special-purpose computer, or another programmable data processing apparatus to enable the function/operation specified in the flowchart and/or block diagram to be implemented when the program codes are executed by the processor or controller. The program codes may be executed entirely on a machine, partially on a machine, partially on a machine and partially on a remote machine as a stand-alone package, or entirely on a remote machine or a server.

In the context of the present disclosure, the machine-readable medium may be tangible media which may include or store programs for use by or in conjunction with an command execution system, apparatus or device. The machine-readable medium may be a machine-readable signal medium or machine-readable storage medium. The machine-readable medium may include, but is not limited to, an electronic, magnetic, optical, electromagnetic, infrared, or semiconductor system, apparatus or device, or any suitable combinations thereof. More specific examples of a machine-readable storage medium may include electrical connections based on one or more wires, a portable computer disk, a hard disk, an RAM, an ROM, an erasable programmable read only memory (EPROM or flash memory), an optical fiber, a compact disk read only memory (CD-ROM), an optical storage device, a magnetic storage device, or any suitable combination thereof.

To provide interaction with a user, the systems and technologies described here can be implemented on a computer. The computer has: a display apparatus (e.g., a cathode-ray tube (CRT) or a liquid crystal display (LCD) monitor) for displaying information to the user; and a keyboard and a pointing apparatus (e.g., a mouse or trackball) through which the user may provide input for the computer. Other kinds of apparatuses may also be configured to provide interaction with the user. For example, a feedback provided for the user may be any form of sensory feedback (e.g., visual, auditory, or tactile feedback); and input from the user may be received in any form (including sound input, speech input, or tactile input).

The systems and technologies described herein can be implemented in a computing system including background components (e.g., as a data server), or a computing system including middleware components (e.g., an application server), or a computing system including front-end components (e.g., a user computer with a graphical user interface or web browser through which the user can interact with the implementation mode of the systems and technologies described here), or a computing system including any combination of such background components, middleware components or front-end components. The components of the system can be connected to each other through any form or medium of digital data communication (e.g., a communication network). Examples of the communication network include: a local area network (LAN), a wide area network (WAN), and the Internet.

The computer system may include a client and a server. The client and the server are generally far away from each other and generally interact via the communication network. A relationship between the client and the server is generated through computer programs that run on a corresponding computer and have a client-server relationship with each other. The server may be a cloud server, a distributed system server, or a server combined with blockchain.

It should be understood that the steps can be reordered, added, or deleted using the various forms of processes shown above. For example, the steps described in the present disclosure may be executed in parallel or sequentially or in different sequences, provided that desired results of the technical solutions disclosed in the present disclosure are achieved, which is not limited herein.

The above specific implementations do not limit the scope of protection of the present disclosure. Those skilled in the art should understand that various modifications, combinations, sub-combinations, and replacements can be made according to design requirements and other factors. Any modifications, equivalent substitutions and improvements made within the spirit and principle of the present disclosure all should be included in the scope of protection of the present disclosure.

## Claims

1. A method of mirroring storage implementation for a memory model, the method comprising:
acquiring, in response to a data update behavior occurring in a memory in a device under test (DUT), update behavior information of the update, the update behavior information being extracted from a bus; and
correspondingly updating data stored in the memory model according to the update behavior information.

2. The method according to claim 1, wherein
the memory model comprises a memory model formed by a register block;
a number of registers in the register block being equal to a depth of the memory, and/or a number of bits of the register being equal to a bit width of the memory.

3. The method according to claim 1, wherein
the data update behavior comprises: external bus input update;
the update behavior information comprises: an update address and data; and
the correspondingly updating data stored in the memory model according to the update behavior information comprises: updating the data corresponding to the update address in the memory model to the data in the update behavior information.

4. The method according to claim 1, wherein
the data update behavior comprises: update after internal processing of the DUT;
the update behavior information comprises: a computation command; and
the correspondingly updating data stored in the memory model according to the update behavior information comprises: acquiring source data corresponding to the computation command, acquiring a computation result generated according to the source data, and updating the computation result into the memory model.

5. The method according to claim 4, wherein the acquiring a computation result generated according to the source data comprises:
sending the source data to a simulation model; and
acquiring the computation result obtained after the simulation model executes computation corresponding to the computation command according to the source data.

6. The method according to any one of claims 1 to 5, further comprising:
acquiring corresponding data from the memory model according to an output address extracted from the bus in response to a memory data output behavior occurring in the DUT, and comparing output data extracted from the bus with the data acquired from the memory model.

7. An apparatus of mirroring storage implementation for a memory model, the apparatus comprising: an information acquisition module and a data update module;
the information acquisition module being configured to acquire, in response to a data update behavior occurring in a memory in a DUT, update behavior information of the update, the update behavior information being extracted from a bus; and
the data update module being configured to correspondingly update data stored in the memory model according to the update behavior information.

8. The apparatus according to claim 7, wherein
the memory model comprises a memory model formed by a register block;
a number of registers in the register block being equal to a depth of the memory, and/or a number of bits of the register being equal to a bit width of the memory.

9. The apparatus according to claim 7, wherein
the data update behavior comprises: external bus input update;
the update behavior information comprises: an update address and data; and
the data update module updates the data corresponding to the update address in the memory model to the data in the update behavior information.

10. The apparatus according to claim 7, wherein
the data update behavior comprises: update after internal processing of the DUT;
the update behavior information comprises: a computation command; and
the data update module acquires source data corresponding to the computation command, acquires a computation result generated according to the source data, and updates the computation result into the memory model.

11. The apparatus according to claim 10, wherein
the data update module sends the source data to a simulation model, and acquires the computation result obtained after the simulation model executes computation corresponding to the computation command according to the source data.

12. The apparatus according to any one of claims 7 to 11, further comprising:
a data comparison module configured to acquire corresponding data from the memory model according to an output address extracted from the bus in response to a memory data output behavior occurring in the DUT, and compare output data extracted from the bus with the data acquired from the memory model.

13. An electronic device, comprising:
at least one processor; and
a memory in communication connection with the at least one processor; wherein
the memory stores commands executable by the at least one processor, and the commands are executed by the at least one processor to enable the at least one processor to perform the method according to any one of claims 1 to 6.

14. A non-transitory computer-readable storage medium storing computer instructions which, when executed by a computer, cause the computer to perform the method according to any one of claims 1 to 6.

15. A computer program product, comprising a computer program, wherein the computer program, when executed by a processor, causes the processor to implement the method according to any one of claims 1 to 6.
